# EUROPEAN PATENT APPLICATION

(11) **EP 0 940 921 A2**
(43) Date of publication of application: **08.09.1999**
(21) Application number: 99101086.9
(22) Date of filing: 26.01.1999
(51) Int. Cl.: H03L 7/085

(54) **A noise-reducing method for charge pump phase-locked loops**

(30) Priority: 04.03.1998 US 34467
(71) Applicant: TRW Inc., Redondo Beach, California 90278 (US)
(72) Inventor: Diorio, Christopher J., Shoreline, Washington 98177 (US)
(74) Representative: Schmidt, Steffen J., Dipl.-Ing.

(57) **Abstract**

A phase-locked loop comprises a charge pump controlled by a one-shot pulse and a comparator output pulse. From a first voltage (132), first and second currents are generated. The first current (134) is transformed into a third current (140) by changing the polarity of the first current using a current minor (110). A first output pulse (148) is generated in response to the comparator output pulse (44) and the third current and a second output pulse (184) is generated in response to the one-shot pulse (52) and the second current (136). The first and second output pulses (148,184) are added to create a charge pump output signal used to adjust the phase-locked loop. The phase-locked loop is locked onto a frequency when the first and second output pulses are approximately equal such that they cancel when added. Creating the first and second currents from the same first voltage (132) creates equal noise components in the first and the second currents (134,136) such that the noise components cancel when the second and third currents (136,140) are added creating a charge pump output signal with reduced noise.

## Description

### BACKGROUND OF THE INVENTION

This invention relates generally to phase-locked loops, and more particularly to an improved charge pump, disposed in the phase-locked loop, which reduces noise in the phase-locked loop.

Phase-locked loops (PLLs) are used in the vast majority of communication systems, both to generate signals and to extract information from received signals. A typical phase-locked loop generates a comparator pulse and compares it to a one-shot pulse having a predetermined magnitude and pulsewidth. The loop is locked onto a desired frequency when the comparator pulse equals the one-shot pulse.

A charge pump is typically used in a phase-locked loop to convert the comparator and one-shot signals into analog signals suitable for controlling a voltage-controlled oscillator (VCO). To accomplish this conversion, first and second voltage rails are typically used to generate first and second voltages. The first voltage rail typically provides a positive voltage and the second voltage rail typically provides a negative voltage. The first voltage is converted to a first current and the second voltage is converted to a second current having a sign opposite that of the first current. A first output pulse is generated in response to the first current and the comparator pulse. A second output pulse is generated in response to the second current and the one-shot pulse. The second output pulse has a sign opposite that of the first output pulse. The first and second output pulses are then added together. Since the first and second output pulses are generated in response to the comparator and one-shot pulses, the first output pulse will have the same pulsewidth and the same magnitude as the second output pulse but will be opposite in sign when the phase-locked loop is locked on a desired frequency. The first and second output pulses will thus cancel when added. Since the comparator pulse and one-shot pulse cancel, the charge pump output signal will be zero and no signal will be sent to the VCO and the VCO will not change the frequency of the phase-locked loop. In this way, the phase-locked loop locks onto a desired frequency. A more detailed description of charge pumps in phase-locked loops can be found in the article "Charge-Pump Phase-Lock Loops," Floyd M. Gardner, IEEE Transactions on Communications, Vol. Com-28, No. 11 November 1980, 1849-1857.

The first and second output pulses contain both do signal components and noise signal components. The noise components have contributions from many sources in the phase-locked loop. Of these noise sources, the current-source reference noise is often the dominant noise source in the phase-locked loop. In conventional PLLs, the noise generated in the current-source voltage reference does not cancel when the first and second output pulses are added because the first and second output pulses are generated from separate voltage references containing unique, incoherent noise components. Adding the first and second output pulses will cancel the do components of the first and second output pulses but not cancel the noise components. The charge pump output signal will then contain noise when the PLL is locked onto a desired frequency. This noise will degrade the performance of the PLL. Consequently, it would be advantageous to employ a circuit topology such that the noise components of the first and second output signals cancel thereby reducing the noise in the phase-locked loop.

### SUMMARY OF THE INVENTION

In accordance with the invention, a charge pump for a phase-locked loop having a one-shot pulse and a comparator pulse is comprised of means for generating a first reference current, means for generating a first generated voltage from the first reference current, means for providing first and second current generators from the first generated voltage, means for generating first and second currents in response to the first and second current generators, and, means for transforming the first current into a third current, the third current being approximately equal to the first current but opposite in sign. The invention further includes means for generating a first output pulse in response to the comparator pulse and the third current, means for generating a second output pulse in response to the one-shot pulse and the second current: and, means for adding the first and second output pulses.

Preferably, the first and second currents are first and second sink currents; and, the third current is a first source current. A reference source, such as a digital to analog converter, provides the first reference current, and, a voltage generator, such as an operational amplifier, converts the first reference current into the first generated voltage. First and second current generators generate the first and second currents in response to the first generated voltage: a current mirror converts the first current into a third current. A first electrical element, such as a first switch, generates a first output pulse in response to the comparator pulse and the third current, and, a second electrical element, such as a second switch, generates a second output pulse in response to the one-shot pulse and the second current. A summer adds the first and second output pulses.

For the preferred embodiment of the invention, the first and the second currents have approximately equal magnitudes; the first the third current have approximately equal magnitudes but opposite sign; and, the first and second output pulses have substantially equal magnitudes and pulsewidths but opposite sign when the phase-locked loop is locked on a desired frequency.

### BRIEF DESCRIPTION OF THE DRAWINGS

Figure 1 is block diagram of a phase-locked loop;
Figure 2 is a diagram of signals present in the phase-locked loop illustrated in Figure 1;
Figure 3 is a diagram of signals present in the charge pump of the phase-locked loop illustrated in Figure 1;
Figure 4 is a block diagram of the present invention;
Figure 5 is a schematic diagram of the preferred embodiment of the first and second current sources disposed in the present invention;
Figure 6 is a schematic diagram of the preferred embodiment of the first and second electrical elements disposed in the present invention; and,
Figure 7 is test data showing noise present in a PLL having the present invention vs. noise present in a standard PLL without the present invention.

### DETAILED DESCRIPTION OF THE INVENTION

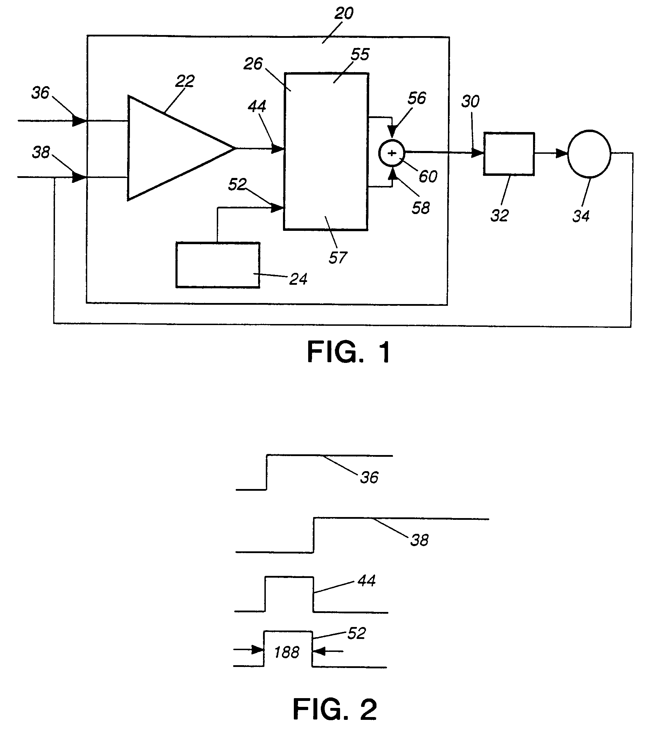

Referring to Figure 1, a typical phase-locked loop 20 has a reference input signal 36, a loop input signal 38, a comparator 22, a one-shot circuit 24, a charge pump 26 and a charge pump output signal 30. The reference input signal 36 (Figs. 1 and 2) and a loop input signal 38 are input to the comparator 22. The comparator 22 subtracts the two signals 36 and 38 and provides a comparator pulse 44 to the charge pump 26. A one-shot circuit 24 (Fig. 1) provides a one-shot pulse 52 to the charge pump 26. The one-shot pulse 52 is a signal with a predetermined pulsewidth 188 (Fig. 2) which represents a predetermined phase offset.

The charge pump 26 (Fig. 1) converts the one-shot 52 and comparator 44 pulses into a charge pump output signal 30 suitable for controlling a voltage-controlled oscillator (VCO) 34. The charge pump 26 delivers the charge pump output signal 30 to the loop filter 32. The loop filter 32 provides the charge pump output signal 30 to the VCO 34. When the pulsewidth of the comparator pulse 44 exceeds the pulsewidth of the one-shot pulse 52, a positive charge pump output signal 30 is generated which instructs the VCO 34 to increase frequency. When the pulsewidth of the one-shot pulse 52 exceeds the pulsewidth of the comparator pulse 44, a negative charge pump output signal 30 is generated which instructs the VCO 34 to decrease frequency. When the pulsewidth of the one-shot pulse 52 and the pulsewidth of the comparator pulse 44 are approximately equal, the VCO 34 does not change condition and the PLL is looked on a desired frequency.

In typical PLL systems, a first voltage 55 and a second voltage 57 are provided to the charge pump 26. The first voltage 55 is typically a positive voltage whereas the second voltage 57 is a negative voltage. A first output signal 56 is generated in response to the comparator pulse 44 and the first voltage 55. A second output signal 58 is generated in response to the one-shot pulse 52 and the second voltage 57. A summer 60 adds the two output signals 56 and 58 and provides the charge pump output signal 30. In typical PLL designs, when the comparator pulse 44 and the one-shot pulse 52 are equal in magnitude and pulsewidth, the first 56 and second 58 output signals are generated with equal magnitudes and pulsewidths, but the signals have opposite polarity, such that when the first 56 and second 58 output signals are added, the signals cancel and the charge pump output signal 30 has zero magnitude. Without a charge pump output signal 30, the VCO 34 will not adjust the frequency. The phase-locked loop will be locked on the desired frequency. A more detailed discussion of phase-looked loops can be found in the article "Phase-Locked Loops: Applications, Performance, Measures, and Summaries of Analytical Results" Chak M. Chie and William C. Lindsey, Phase-Locked Loops, IEEE Press, 1985.

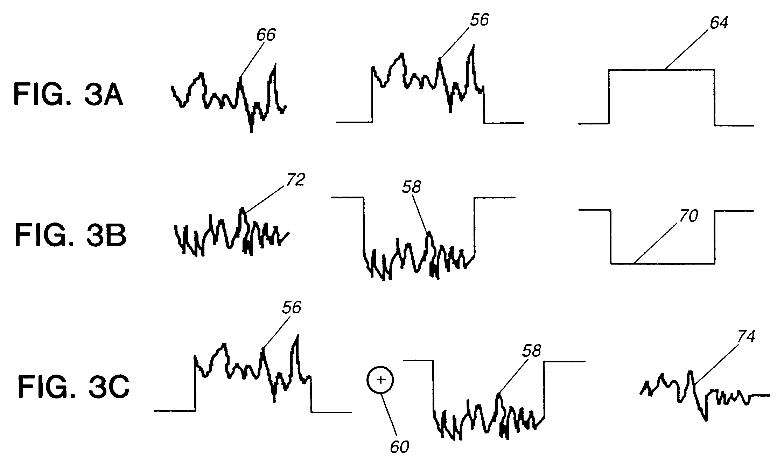

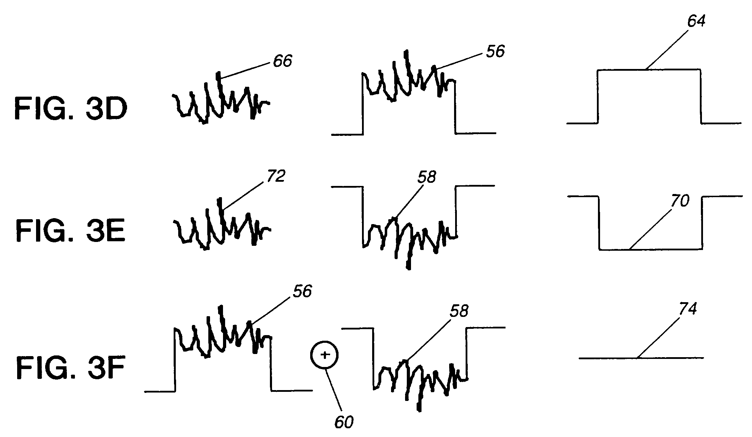

In typical phase-locked loop systems, the charge pump output signal 30 never actually has zero magnitude. Referring now to Figures 3a - 3f, it can be appreciated that in typical PLLs, the first voltage signal 55 (Fig. 1) imposes a first noise signal 66 on the comparator pulse 44 (Fig. 2) and the second voltage signal 57 (Fig. 1) imposes a second noise signal 72 on the one-shot pulse 52 (Fig. 2). Since the first 55 and second 57 voltage signals are generated from separate sources, the first 66 and second 72 noise signals will in general not have the same magnitude. Then, when the first 56 and second 58 output pulses are added by the summer 60, the do components 64 and 70 will cancel, but the noise components 66 and 72 will not. The resulting signal 74 will become the charge pump output signal 30 (Fig. 1) and will add noise to the phase-locked loop which can degrade the performance of the phase-locked loop. The present invention overcomes this problem by creating the first 55 and second 57 voltages from the same source. By generating the first 55 and second 57 voltage signals from the same source, the first 66 and second 72 noise signals will have substantially similar magnitudes. Therefore, when the first 56 and second 58 output pulses are added by the summer 60, the dc components 64 and 70 will cancel; the noise components 66 and 72 will also cancel. The resulting signal 74 will be substantially free of noise.

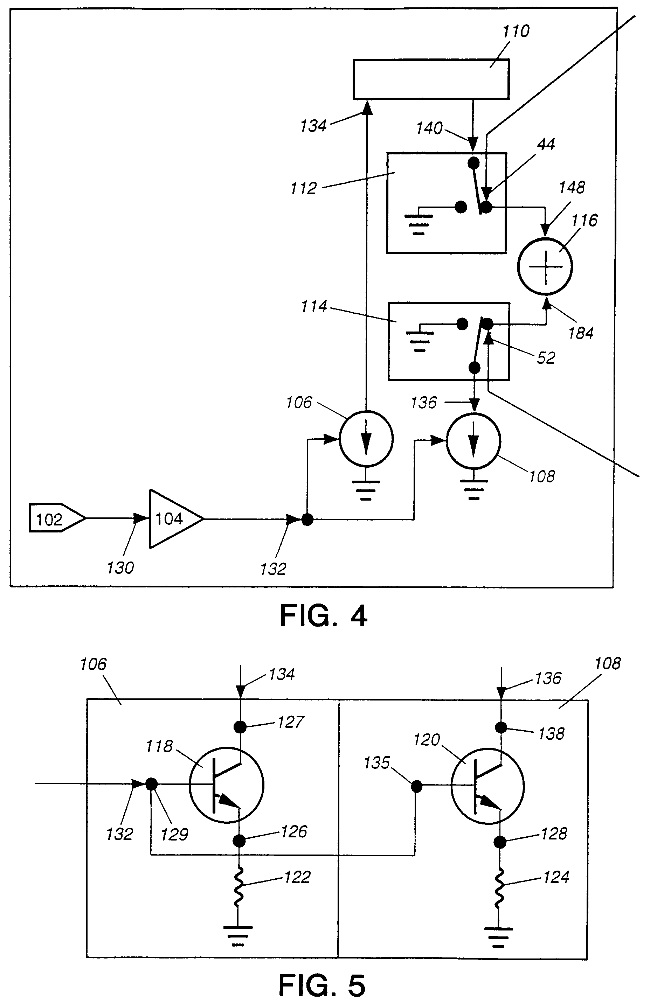

Referring to Figure 4, the invention includes means for generating a first reference current 130. The first reference current means is a reference source 102 which provides a first reference current 130. For the preferred embodiment of the invention, a digital to analog converter (DAC) is the reference source 102. The invention also includes means for generating a first generated voltage 132. The first generated voltage means is a first voltage generator 104 coupled to the reference source 102. The first voltage generator 104 is adapted to receive the first reference current 130, and converts the first reference current 130 into a first generated voltage 132. For the preferred embodiment of the invention, an operational amplifier is used as the first voltage generator 104. In an alternate embodiment of the invention, a fixed voltage source replaces both the reference source 102 and the first voltage generator 104. For this alternate embodiment, the fixed voltage source provides the first generated voltage 132.

The invention includes means for providing a first and a second current generator from the first generated voltage 132. The first current generator means is a first current generator 106 coupled to the first voltage generator 104 and is also adapted to receive the first generated voltage 132. The first current generator 106 provides the means to generate a first current 134 in response to the first generated voltage 132. The second current generator means is a second current generator 108 coupled to the voltage generator 104 and adapted to receive the first generated voltage 132. The second current generator 108 provides the means to generate a second current 136 in response to the first generated voltage 132. The first current 134 has a first magnitude and the second current 136 has a second magnitude. For the preferred embodiment of the invention, the first 134 and second 136 currents are first and second sink currents respectively. For an alternative embodiment of the invention, the first 134 and second 136 currents are first and second source currents respectively.

The first 106 and second 108 current generators have substantially similar electrical characteristics resulting in the first and second magnitudes being substantially similar to each other. Referring now to Figure 5, for the preferred embodiment of the invention, the first 106 and second 108 current generators are first and second bipolar junction transistors. The first bipolar junction transistor 106 comprises a first transistor 118 and a first resistor 122. The second bipolar junction transistor 108 comprises a second transistor 120 and a second resistor 124. The first transistor 118 has a first emitter 126, a first base 129 and a first collector 127. The second transistor 120 has a second emitter 128 , a second base 135 and a second collector 138. The first base 129 and the second base 135 are both coupled to the first voltage generator 104 (Fig. 4). The first 129 and second 135 bases (Fig. 5) of the first 118 and second 120 transistors are both adapted to receive the first generated voltage 132. The first emitter 126 is coupled to the first resistor 122 and the second emitter 128 is coupled to the second resistor 124. For the preferred embodiment of the invention, the first 134 and second 136 currents are first and second sink currents, and, the first 134 and second 136 sink currents are provided at the first 127 and the second 138 collector respectively. For the preferred embodiment, the first 118 and second 120 transistors have substantially equal electrical characteristics and the first 122 and second 124 resistors have substantially equal resistances. Configuring the first 106 and second 108 current generators in this manner will result in the first 134 and second 136 currents having approximately equal electrical characteristics including equal magnitudes. Other transistors can be used in place of bipolar junction transistors 118 and 120, such as n-channel MOSFETs, as is well known to those practiced in the art.

The invention also includes means for transforming the first current 134 into a third current; the third current being approximately equal to the first current 134 but opposite in sign. Referring back to Figure 4, for the preferred embodiment of the invention, the transforming means is a current mirror 110 coupled to the first current generator 106 and adapted to receive the first current 134. A current mirror 110 is a commercially known method to those skilled in art to change the sign of a current. The current mirror 110 transforms the first current 134 into a third current 140 by changing the sign of the first current 134. For example, if the first current 134 has a positive sign, the third current 140 will be substantially similar but have a negative sign. A more detailed discussion on current-mirrors can be found in The Art of Electronics, by Paul Horowitz and Winfield Hill, Cambridge University Press, 1989, 2nd ed. at pg. 88. For the preferred embodiment of the invention, the first current 134 is a first sink current and the current mirror 110 transforms the first sink current into a first source current. For an alternative embodiment of the invention, the first current 134 is a first source current and the current mirror 110 transforms the first source current into a first sink current. Alternative current-mirror implementations can be used, as is well known to those practice in the art.

The invention further includes both means for generating a first output pulse 148 (Fig. 4) in response to the comparator pulse 44 and the third current 140 and means for generating a second output pulse 184 in response to the one-shot pulse 52 and the second current 136. The means for generating a first output pulse 148 is a first electrical element 112 coupled to the current mirror 110. The first electrical element 112 is configured to generate a first output pulse 148 in response to the comparator pulse 44 and the third current 140 (Fig. 4). The means for generating a second output pulse 184 is a second electrical element 114 coupled to the second current generator 108. The second electrical element 114 is configured to generate a second output pulse 144 in response to the one-shot pulse 52 and the second current 136.

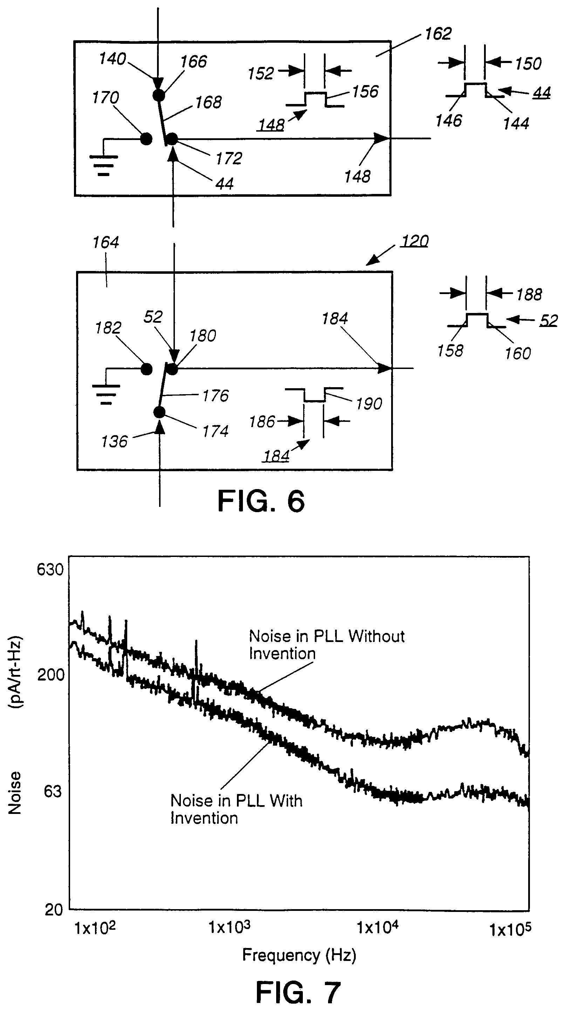

Referring now to Figure 6, for the preferred embodiment of the invention, the first electrical element 112 is a first switch 162 and the second electrical element 120 is a second switch 164. For the preferred embodiment of the invention, the third current 140 is a first source current and has a negative magnitude necessitating that an n-type device be used as the first switch 162. And, the second current 136 is a second sink current having a positive magnitude necessitating that a p-type device or a diode be used as the second switch 164. Schematically, for the preferred embodiment of the invention, the first port 166 of the first switch 162 is adapted to receive the first source current 140. The switch arm 168 is connected to ground through the first ground terminal 170 until the comparator pulse 44 is received at the second port 172 of the first switch 162. The leading edge 144 of the comparator pulse 44 activities the first switch 162 closing the switch by connecting the first switch arm 168 to the second port 172. This allows the first source current 140 and the comparator pulse 44 to combine. The lagging edge 146 of the comparator pulse 44 causes the switch 162 to open by connecting the first switch arm 168 to the first ground terminal 170. In this way, the first output pulse 148 is generated in response to the comparator pulse 44 and the first source current 140. The first output pulse 148 has substantially the same first pulsewidth 152 as the comparator pulsewidth 150 with a first output magnitude 156 equal to the first source current magnitude.

In addition, for the preferred embodiment of the invention, the third port 174 of the second switch 164 is adapted to receive the second sink current 136. The second switch arm 176 is normally connected to ground through the second ground terminal 178 of the second switch 164 until the one-shot pulse 52 (Figs. 1 and 7) is received at the fourth port 180 of the second switch 164. The leading edge 158 of the one-shot pulse 52 activates the second switch 164 closing the switch by connecting the second switch arm 176 to the fourth port 180. This allows the second sink current 136 and the one-shot pulse 52 to combine. The lagging edge 160 of the one-shot pulse 52 causes the switch 164 to open by connecting the second switch arm 176 to the second ground terminal 182. In this way, the second output pulse 184 is generated in response to the one-shot pulse 52 and the second sink current 136. The second output pulse 184 has substantially the same second pulsewidth 186 as the one-shot pulsewidth 188 with a second output magnitude 190 equal to the magnitude of the second sink current. For alternative embodiments of the invention, the first and second switches can be MOSFETs, HEMTs, MESFETS, n-type devices, p-type devices or the like.

The first output pulse 148 has its magnitude 156 and pulsewidth 152, and the second output pulse 184 has its magnitude 190 and pulsewidth 186. For the preferred embodiment of the invention, the one-shot pulse 52 has substantially equal electrical characteristics as the comparator pulse 44 when the PLL is locked onto a desired frequency. Therefore, the pulsewidth 152 of the first output pulse 148 will be substantially equal to the pulsewidth 186 of the second output pulse 184 when the PLL is locked on a desired frequency. Because the magnitude of the third current 140 is approximately equal to the magnitude of the second current 136 but opposite in sign, the magnitude 156 of the first output pulse 148 will be substantially equal to the magnitude 190 of the second output pulse 184 but of opposite in sign when the PLL is locked on a desired frequency.

The invention includes means for adding the first output pulse 148 and the second output pulse 184. Referring to Figure 4, the adding means is a summer 116 which adds the first 148 and second 184 output pulses to generate the charge pump output signal 30. In the preferred embodiment of the invention, when the PLL is locked onto a desired frequency, the first 148 and second 184 output pulses have the same pulsewidths 152 and 186 and the same magnitudes 156 and 190. But, the magnitudes 156 and 190 have opposite signs such that when the first 148 and second 184 output pulses are added by the summer 116, they substantially cancel each other. In this manner, the present invention employs a circuit topology such that both the dc components and the noise components of the first 148 and second 184 output signals cancel thereby reducing the overall noise in the phase-locked loop.

As can be seen in Figure 7, the noise present in a PLL is reduced from the noise level's present in a typical PLL using the present invention.

## Claims

1. A charge pump disposed in a phase-locked loop having a one-shot pulse and a comparator pulse comprising:
means for generating a first reference current;
means for generating a first generated voltage from said first reference current;
means for providing a first and a second current generator from said first generated voltage;
means for generating a first current in response to said first current generator;
means for generating a second current in response to said second current generator;
means for transforming said first current into a third current, said third current being approximately equal to said first current but opposite in sign;
means for generating a first output pulse in response to said comparator pulse and to said third current;
means for generating a second output pulse in response to said one-shot pulse and to said second current; and,
mean for adding said first output pulse and said second output pulse.

2. The charge pump of claim 1, wherein said first current is a first sink current, said second current is a second sink current; and, said third current is a first source current; or
wherein said first current is a first source current, said second current is a second source current; and, said third current is a first sink current; and/or
wherein said first current generator has substantially similar electrical characteristics to said second current generator; and/or
wherein said first current has a first magnitude and said second current has a second magnitude, said first magnitude being approximately equal to said second magnetude; and/or
wherein said first current has a first magnitude and said third current has a third magnitude, said third magnitude being approximately equal to said first magnitude but being of opposite sign; and/or
wherein said one-shot pulse and said comparator pulse have substantially equal electrical characteristics when said phase-locked loop is locked on a desired frequency; and/or
wherein said first output pulse has a fourth magnitude and a first pulsewidth, said second output pulse has a fifth magnitude and a second pulsewidth, said first pulsewidth being substantially equal to said second pulsewidth and said fourth magnitude being substantially equal to said fifth magnitude but of opposite sign when said phase-locked loop is locked on a desired frequency; and/or
wherein said means for generating a first generated voltage is a fixed voltage source; and/or
wherein said means for transforming said first current into said third current is a current mirror; and/or
wherein said means for generating a first output pulse is a first switch and said means for generating a second output pulse is a second switch.

3. The charge pump of claim 1, wherein said means for generating a first generated voltage comprises a digital to analog converter coupled to a reference generator.

4. The charge pump of claim 3, wherein said reference generator is an operational amplifier.

5. A charge pump, disposed in a phase-locked loop having a one-shot pulse and a comparator pulse, said charge pump comprising:
a reference source for providing a first reference current;
a voltage generator coupled to said reference source, said voltage generator configured to convert said first generated current into a first generated voltage;
a first current generator coupled to said voltage generator, said first current generator configured to generate a first current in response to said first generated voltage;
a second current generator coupled to said voltage generator, said second current generator configured to generate a second current in response to said first generated voltage;
a current mirror coupled to said first current generator, said current mirror configured to convert said first current into a third current, said third current approximately equal to said first current but opposite in sign;
a first electrical element coupled to said current mirror, said first electrical element configured to generate a first output pulse in response to said comparator pulse and said third current;
a second electrical element coupled to said second current source, said second electrical element configured to generate a second output pulse in response to said one-shot pulse and said second current; and,
a summer configured to add said first output pulse and said second output pulse.

6. The charge pump of claim 5, wherein said first current is a first sink current, said second current is a second sink current; and, said third current is a first source current; or
wherein said first current is a first source current, said second current is a second source current; and, said third current is a first sink current; and/or
wherein said first current has a first magnitude and said second current has a second magnitude, said first magnitude being approximately equal to said second magnetude; and/or
wherein said first current has a first magnitude and said third current has a third magnitude, said third magnitude being approximately equal to said first magnitude but being of opposite sign; and/or
said first output pulse has a fourth magnitude and a first pulsewidth, said second output pulse has a fifth magnitude and a second pulsewidth, said first pulsewidth being substantially equal to said second pulsewidth and said forth magnitude being substantially equal to said fifth magnitude but of opposite sign when said phase-locked loop is locked on a desired frequency; and/or
wherein said one-shot pulse and said comparator pulse have substantially equal electrical characteristics when said phase-locked loop is locked on a desired frequency; and/or
wherein said reference source is a digital to analog converter; and/or
wherein said voltage generator is an operational amplifier or a voltage reference; and/or
wherein said first electrical element is a first switch and said second electrical element is a second switch.

7. A phase-locked loop having a reference input signal, said phase-locked loop comprising:
a voltage controlled oscillator (VCO) configured to provide a loop input signal;
a one-shot circuit configured to provide a one-shot pulse;
a comparator responsive to said loop input signal and a reference input signal, said comparator being operative to compare said loop input signal and said reference input signal and to develop a comparator pulse in response thereto;
a first voltage generator configured to provide a first generated voltage;
a charge pump comprising a first current generator, a second current source, a current mirror, a first electrical element, a second electrical element and a summer;
said first current generator providing a first current in response to said first generated voltage, said second current generator providing a second current in response to said first generated voltage, said first and second currents being generated from said first generated voltage;
said current mirror generating a third current in response to said first current, said third current being approximately equal to said first current but opposite in sign;
said first electrical element generating a first output pulse in response to said third current and said comparator pulse, said second electrical element generating a second output pulse in response to said second current and said one-shot pulse; and
said summer being operative to add said second current and said third current to generate a charge pump output signal in response thereto.

8. The phase-locked loop of claim 7, wherein said first current is a first sink current, said second current is a second sink current, said third current is a first cource current; or
wherein said first current is a first source current, said second current is a second source current, said third current is a first sink current; and/or
wherein said first current has a first magnitude and said second current has a second magnitude, said first magnitude being approximately equal to said second magnitude; and/or
wherein said first output pulse has a fourth magnitude and a first pulsewidth, said second output pulse has a fifth magnitude and a second pulsewidth, said first pulsewidth being substantially equal to said second pulsewidth and said fourth magnitude being substantially equal to said fifth magnitude but of opposite sign when said phase-locked loop is locked on a desired frequency; and/or
wherein said one-shot pulse and said comparator pulse have substantially equal electrical characteristics when said phase-locked loop is locked on a desired frequency; and/or
wherein said first electrical element is a first switch and said second electrical element is a second switch.

9. A method for reducing noise in the charge pump of a phase-locked loop, said phase-locked loop having a one-shot pulse and a comparator pulse said method comprising the steps of:
generating a first generated voltage;
providing a first and a second current generator from said first generated voltage;
generating a first current in response to said first current generator;
generating a second current in response to said second current generator;
transforming said first current into a third current, said third current approximately equal to said first current but opposite in sign;
generating a first output pulse in response to said comparator pulse and to said first current;
generating a second output pulse in response to said one-shot pulse and to said third current; and,
adding said first output pulse and said second output pulse.

10. The method of claim 9, wherein said step of generating a first current comprises the step of generating a first sink current, said step of generating a second current comprises the step of generating a second sink current; and, said step of generating a third current comprises the step of generating a first source current; or
wherein said step of generating a first current comprises the step of generating a first source current, said step of generating a second current comprises the step of generating a second source current; and, said step of generating a third current comprises the step of generating a first sink current.
